(19) Europäisches Patentamt
European Patent Office
Office européen des brevets

(11) EP 0 462 023 B1

(12) FASCICULE DE BREVET EUROPEEN

(45) Date de publication et mention
de la délivrance du brevet:
**16.07.1997   Bulletin 1997/29**

(51) Int Cl.6: **H03K 17/16**, H03K 17/04

(21) Numéro de dépôt: **91420169.4**

(22) Date de dépôt: **29.05.1991**

(54) **Commutateur statique**

Statischer Schalter

Static switch

(84) Etats contractants désignés:
**BE CH DE ES GB IT LI SE**

(30) Priorité:   **12.06.1990  FR 9007385**

(43) Date de publication de la demande:
**18.12.1991   Bulletin 1991/51**

(73) Titulaire: **SCHNEIDER ELECTRIC SA
92100 Boulogne Billancourt (FR)**

(72) Inventeurs:
• **Perichon, Pierre
  F-38050 Grenoble Cedex (FR)**
• **Beranger, Bruno
  F-38050 Grenoble Cedex (FR)**

• **Mertz, Jean-Luc
  F-38050 Grenoble Cedex (FR)**

(74) Mandataire: **Jouvray, Marie-Andrée et al
Schneider Electric SA,
Sce. Propriété Industrielle
38050 Grenoble Cédex 09 (FR)**

(56) Documents cités:
**EP-A- 0 272 514         EP-A- 0 369 448**

• **PATENT ABSTRACTS OF JAPAN, vol. 13, no.
123 (E-733)[3471], 27 mars 1989; & JP-A-63 292
547**

# Description

L'invention concerne un commutateur statique comportant un semi-conducteur, destiné à être connecté en série avec une charge aux bornes d'une tension d'alimentation continue, et des moyens de contrôle d'une tension de commande du semi-conducteur comportant des moyens de mesure du courant parcourant le semi-conducteur et des moyens de régulation de la tension de commande du semi-conducteur en fonction dudit courant.

Le document FR-A-2.618.276 mentionne dans son introduction un commutateur de ce type comportant des moyens destinés à assurer son ouverture lorsque le courant dans le commutateur dépasse une valeur prédéterminée pendant un certain temps (fonction disjoncteur) et limitant, par régulation du courant, le courant dans le semi-conducteur à une valeur élevée, inférieure aux limites en courant du semi-conducteur, pendant la durée de la temporisation. Pour éviter des disjonctions intempestives, notamment lors de la fermeture du commutateur sur une charge capacitive, la temporisation doit être suffisamment longue. Or, en cas de défaut, la puissance dissipée dans le semi-conducteur est élevée pendant la durée de la temporisation, ce qui rend souhaitable une limitation de cette durée. Pour concilier ces contraintes opposées et permettre une commutation progressive limitant les surtensions ou les surintensités, le document précité propose un dispositif de commutation, destiné notamment à l'aéronautique, comportant les mises en service successives, en fonction du courant traversant le dispositif, de semi-conducteurs associés à des résistances et disposés en parallèle de manière à former un rhéostat électronique.

La présente invention a pour but un commutateur statique, notamment un commutateur de puissance, pouvant être utilisé sans inconvénient avec une charge capacitive. Une telle charge est, par exemple, constituée par la capacité d'un câble, par un condensateur ou par une alimentation à découpage.

Le commutateur selon l'invention est caractérisé en ce que les moyens de contrôle comportent un circuit à retard sur une entrée duquel est appliqué un signal de fermeture ou d'ouverture du commutateur, des moyens connectés à une sortie du circuit à retard, destinés à produire une tension nominale de commande du semi-conducteur après une période de temporisation prédéterminée suivant l'application d'un signal de fermeture à l'entrée du circuit à retard, la tension de commande régulée produite par les moyens de régulation étant appliquée au semi-conducteur pendant ladite période de temporisation de manière à ce que le semi-conducteur fonctionne, pendant cette période, en générateur de courant, limitant le courant à une valeur prédéterminée très inférieure au courant nominal du commutateur.

A titre d'exemple, le courant peut être limité à 100mA pendant 2s, avant de passer à sa valeur nominale, par exemple 30A.

Le commutateur comporte, de préférence, également des moyens de mise à la masse de l'électrode de commande du semi-conducteur lorsqu'un signal d'ouverture du commutateur est appliqué à l'entrée du circuit à retard ainsi que pendant un temps prédéterminé, très court, suivant l'application d'un signal de fermeture de manière à permettre une remise à zéro des moyens de régulation.

Selon un développement de l'invention, les moyens de mesure du courant sont constitués par un fusible connecté en série avec le semi-conducteur, la tension aux bornes dudit fusible, représentative dudit courant, étant appliquée à l'entrée des moyens de régulation.

L'utilisation d'un shunt de mesure constitué par un fusible ou par un élément de résistance équivalente permet de réduire au maximum les pertes par effet thermique, lorsque le commutateur est traversé par son courant nominal. Dans le cas d'un fusible, celui-ci assure normalement la protection dans le cas où l'électronique du disjoncteur est hors service. Il peut alors servir en outre de shunt, peu précis, sans coût supplémentaire. Si le courant régulé, pendant la période de temporisation suivant la fermeture du commutateur, est de l'ordre de 100mA, la tension aux bornes du fusible est de l'ordre de quelques centaines de microvolts. Cette tension continue très faible, appliquée à l'entrée des moyens de régulation, constitués par un circuit amplificateur et un comparateur, nécessite à priori l'utilisation d'un amplificateur ayant une tension d'offset très faible, donc relativement coûteux.

Selon un développement de l'invention, les moyens de régulation comportent un circuit amplificateur à correction automatique de la tension d'offset, ce qui permet d'utiliser des amplificateurs opérationnels bon marché, dont la tension d'offset est largement supérieure à la tension qui est appliquée sur leurs entrées.

Un tel circuit amplificateur comporte, de préférence, un premier amplificateur opérationnel dont la sortie est reliée à une première entrée d'un second amplificateur opérationnel et à une diode sans seuil dont la cathode est connectée à un condensateur, la tension aux bornes du condensateur étant appliquée à la seconde entrée du second amplificateur opérationnel dont la sortie constitue la sortie du circuit amplificateur.

Le commutateur peut remplir la fonction d'un contacteur, et/ou d'un disjoncteur. Lorsque le commutateur fonctionne en contacteur, les signaux de fermeture et d'ouverture sont des signaux de commande externes. Pour fonctionner en disjoncteur, un commutateur, de préférence du type décrit ci-dessus, comporte des moyens de détection de défaut produisant un signal d'ouverture en cas de détection d'une surcharge ou d'un court circuit, et des moyens de réarmement produisant un signal de fermeture.

Classiquement les moyens de détection de défaut comportent un dispositif, par exemple un shunt, de mesure du courant de défaut.

Selon un développement de l'invention, les moyens de détection de défaut du commutateur comportent des moyens de détection de la tension aux bornes du semiconducteur et des moyens de production du signal d'ouverture lorsque cette tension dépasse un premier seuil prédéterminé pendant un temps prédéterminé, représentatif d'une surcharge ou lorsqu'elle dépasse un second seuil prédéterminé, représentatif d'un court-circuit, pour lequel le semi-conducteur est saturé.

On tient compte du fait que le courant nominal traversant le commutateur est inférieur au courant de saturation de celui-ci et correspond à une tension prédéterminée, faible, aux bornes du semi-conducteur, tandis qu'en cas de court-circuit, notamment, le semi-conducteur se sature et la tension à ses bornes augmente. La saturation du semi-conducteur en cas de court-circuit permet également de limiter le courant de défaut dans le commutateur.

Selon un mode particulier de réalisation, le collecteur du semi-conducteur étant connecté à la tension d'alimentation continue par l'intermédiaire de la charge, les moyens de mesure de la tension aux bornes du semi-conducteur comportent une diode dont la cathode est connectée au collecteur du semi-conducteur, et polarisée de manière à être bloquée lorsque ladite tension collecteur dépasse le second seuil, les moyens de détection d'un court-circuit produisant un signal d'ouverture lorsque ladite diode est bloquée.

Selon un mode de réalisation préférentiel de l'invention, le semi-conducteur est un transistor bipolaire à grille isolée (transistor de type IGBT), mais l'invention est également applicable à un transistor bipolaire ou à un transistor de type MOSFET.

D'autres avantages et caractéristiques ressortiront plus clairement de l'exposé qui va suivre de modes particuliers de réalisation de l'invention, donnés à titre d'exemples non limitatifs et représentés aux dessins annexés sur lesquels:

La figure 1 illustre, de façon schématique, un commutateur selon l'invention.

La figure 2 représente, en fonction du temps, la variation du courant dans un commutateur selon l'invention lors de sa fermeture.

La figure 3 illustre certains détails d'une variante de réalisation d'un commutateur selon l'invention.

La figure 4 est une représentation d'un mode de réalisation particulier du circuit amplificateur du commutateur selon la figure 1.

La figure 5 représente la caractéristique courant/tension d'un transistor de type IGBT.

La figure 6 illustre le principe de la détection d'un défaut dans un commutateur statique.

La figure 7 représente un mode de réalisation particulier d'un commutateur/disjoncteur selon l'invention.

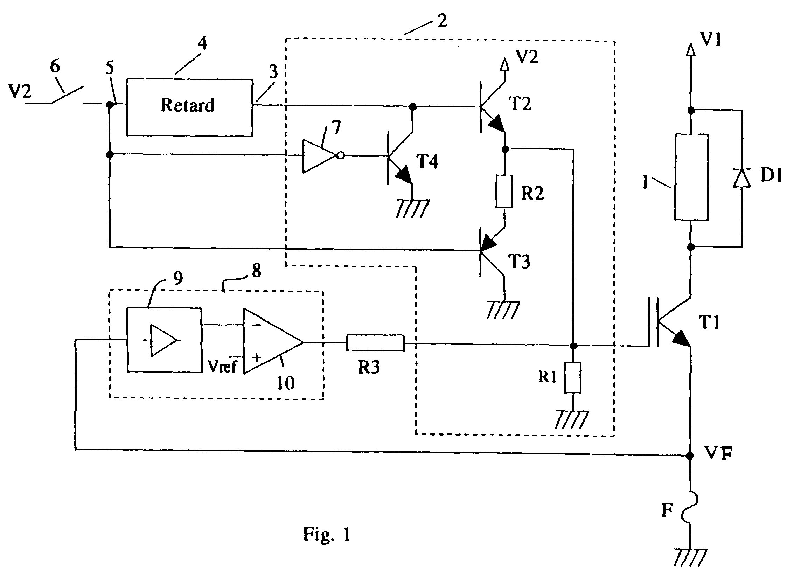

Le commutateur statique selon la figure 1 est destiné à être connecté en série avec une charge 1 aux bornes d'une tension d'alimentation continue V1. De manière classique, une diode D1 est disposée en parallèle sur la charge pour limiter les surtensions aux bornes de celle-ci. Un tel commutateur est plus particulièrement un commutateur de puissance destiné à alimenter avec une tension élevée, par exemple 270V, une charge pouvant être capacitive.

Dans le mode de réalisation représenté à la figure 1, le commutateur comporte un transistor T1, de type IGBT, connecté à la masse par l'intermédiaire d'un fusible F. Une tension d'alimentation V2, par exemple de l'ordre de 8V, alimente l'ensemble des composants électroniques du circuit de contrôle du transistor T1.

La grille du transistor T1 est connectée à un circuit de contrôle dont l'étage de sortie 2 comporte une résistance R1 connectant la grille à la masse et un transistor T2, de type npn, dont la base est connectée à une sortie 3 d'un circuit à retard 4 et connectant la grille à la tension d'alimentation V2. Un signal de fermeture ou d'ouverture du commutateur est appliqué à l'entrée 5 du circuit à retard 4 par l'intermédiaire d'un circuit de commutation 6. La grille du transistor T1 est également connectée à la masse par un circuit de mise à zéro contrôlé par le signal d'entrée du circuit à retard. Le circuit de mise à zéro comporte, par exemple, une résistance R2 en série avec un transistor T3, de type pnp, dont la base est reliée à l'entrée 5 du circuit à retard. Un transistor T4, dont la base est connectée par un inverseur 7 à l'entrée 5 de circuit à retard, connecte à la masse la base du transistor T2. La grille du transistor T1 est, de plus, connectée, par une résistance R3, à la sortie d'un circuit de régulation 8 à l'entrée duquel est appliquée la tension aux bornes du fusible F.

L'ensemble décrit ci-dessus fonctionne de la manière suivante:

Lorsque le circuit de commutation 6 est ouvert, un signal logique à l'état bas est disponible à l'entrée 5 rendant conducteur le transistor T3. Ce signal logique, appliqué à l'entrée de l'inverseur 7, rend également conducteur le transistor T4, bloquant le transistor T2. La tension de commande appliquée à la grille du transistor T1 est nulle et le transistor T1 est bloqué.

Lorsque le circuit de commutation 6 est fermé, un signal logique à l'état haut est disponible à l'entrée 5, bloquant les transistors T3 et T4. Le signal disponible à la sortie 3 du circuit à retard 4, initialement à l'état bas, bloquant le transistor T2, passe à l'état haut après une temporisation t1 d'une durée prédéterminée, par exemple 2s, définie par le circuit à retard. Après cette temporisation t1, le transistor T2 devient conducteur et la tension d'alimentation V2 est appliquée à la grille du transistor T1. Cette tension d'alimentation V2 correspond à la tension nominale de commande du transistor T1 et un courant nominal prédéterminé, par exemple 30A, traverse le transistor T1 pour alimenter la charge.

Pendant la durée de temporisation t1, après l'application d'un signal de fermeture au circuit de contrôle du commutateur, les transistors T2, T3 et T4 sont bloqués et la tension de la grille du transistor T1 est contrôlée par le circuit de régulation 8 qui asservit le courant dans le commutateur à une valeur de référence. Le fusible F sert de shunt de mesure, la tension à ses bornes étant proportionnelle au courant traversant le transistor T1. Cette tension est appliquée aux bornes du circuit de régulation 8 comportant un circuit amplificateur 9 dont la sortie est reliée à une entrée (-) d'un comparateur 10. L'autre entrée (+) du comparateur 10 est connectée à une tension de référence Vref, pouvant, par exemple, être dérivée de la tension d'alimentation V2 par un pont diviseur ou une résistance ajustable. Le transistor T1 fonctionne alors en générateur de courant, la valeur du courant étant limitée à une valeur, par exemple 100mA, très inférieure au courant nominal du commutateur. La valeur de ce courant de démarrage est fixée par la tension de référence Vref.

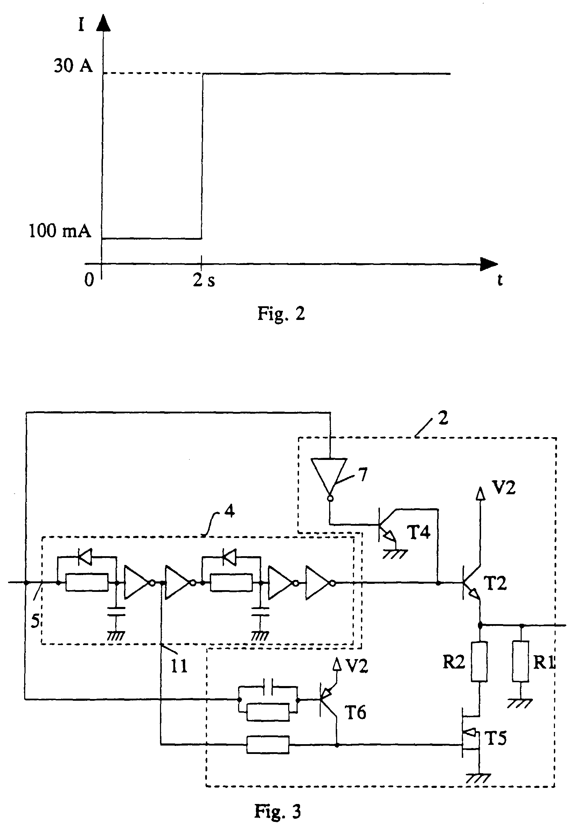

La figure 2 illustre en fonction du temps, le variation du courant I dans le commutateur selon la figure 1, lors de sa fermeture. Le commutateur fonctionne d'abord en générateur de courant, produisant un courant constant, de 100mA, pendant la durée de la temporisation (2s), puis est parcouru par un courant nominal, par exemple 30A, beaucoup plus élevé. La durée de la temporisation est choisie de manière à permettre à une charge 1 capacitive d'être chargée sous courant constant jusqu'à la tension continue V1 avant la fin de la temporisation, éliminant ainsi toute surcharge au démarrage due à une charge trop rapide de la charge capacitive.

La figure 3 représente plus en détail un mode particulier du circuit à retard 4 ainsi qu'une variante de l'étage de sortie 2.

Dans cette variante le transistor T3, de type pnp, de la figure 1 est remplacé par un transistor T5, de type MOS, dont la base est connectée à une seconde sortie 11 du circuit à retard ainsi qu'au collecteur d'un transistor T6, de type pnp, dont l'émetteur est relié à la tension d'alimentation V2 et dont la base est connectée à l'entrée 5 du circuit à retard.

Le circuit à retard est conçu de manière à fournir sur sa seconde sortie 11 un signal complémentaire du signal d'entrée 5 mais retardé d'un second temps prédéterminé t2, beaucoup plus court que la temporisation t1 mentionnée précédemment. A titre d'exemple, ce second retard t2 peut être de l'ordre du dizième de la temporisation t1.

Avec cette variante de réalisation, un signal d'ouverture du commutateur (0 à l'entrée 5) rend, comme précédemment, conducteur le transistor T4 et bloque le transistor T2. Simultanément il rend conducteur les transistors T6 et T5, forçant à zéro la grille du transistor T1. Lorsqu'un signal de fermeture (1 à l'entrée 5) est appliqué à un instant to, les transistors T4 et T6 se bloquent. La sortie 11, initialement à 1, reste à 1 pendant une durée égale au retard t2, T5 restant conducteur jusqu'à l'instant to+t2 où il se bloque. La sortie 3 initialement à O, reste à O pendant une durée égale à la temporisation t1, T2 restant bloqué jusqu'à l'instant to+t1 où il devient conducteur. Le cycle de fermeture se divise donc en trois périodes:

- Une première période entre to et to+t2, où T2 étant bloqué et T5 conducteur, la grille du transistor T1 est forcée à O.
- Une seconde période, entre to+t2 et to+t1, où T2 et T5 étant bloqués, la tension de grille du transistor T1 est contrôlée par le circuit de régulation 8, le transistor T1 fonctionnant en générateur de courant.
- Une troisième période, après l'instant to+t1 où T5 est bloqué et T2 conducteur, commandant le fonctionnement du transistor T1 à sa tension nominale.

La première période est destinée à permettre la remise à zéro du circuit amplificateur 9 du circuit de régulation 8. En effet, pendant cette période, aucun courant ne traverse le fusible F et la tension appliquée à l'entrée du circuit amplificateur est nulle.

Grâce à l'utilisation du fusible F, de résistance très faible, comme shunt de mesure du courant on n'introduit pas dans le circuit de résistance importante. Cependant la tension aux bornes du fusible est très faible, par exemple 200 microvolts pour un courant de 100mA.

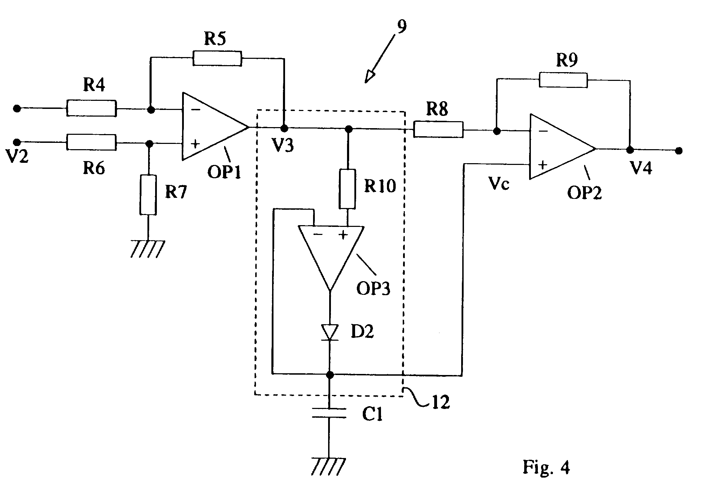

Pour permettre la mesure d'une telle tension, le mode de réalisation préférentiel du circuit amplificateur 9, représenté à la figure 4, comporte une correction automatique de la tension d'offset.

Ce circuit amplificateur comporte un premier amplificateur opérationnel OP1. L'entrée inverseuse du premier amplificateur OP1 est connectée à l'entrée du circuit 9 par une résistance R4, et à la sortie du premier amplificateur par une résistance R5. Son entrée non inverseuse est connectée au point commun à deux résistances R6 et R7 disposées en série entre la tension d'alimentation V2 et la masse, de manière à fixer la tension d'offset Vo de l'amplificateur OP1 à une valeur prédéterminée, par exemple +10mV, supérieure à la tension d'offset maximum(+/-7mV, par exemple) donnée par le constructeur.

La sortie de l'amplificateur opérationnel OP1 est connectée à la masse par l'intermédiaire d'une diode sans seuil 12 en série avec un condensateur C1. La tension Vc aux bornes du condensateur C1 est appliquée à l'entrée non-inverseuse d'un second amplificateur opérationnel OP2, dont l'entrée inverseuse est reliée à la sortie du premier amplificateur OP1 par une résistance R8 et à sa propre sortie par une résistance R9. La sortie du second amplificateur OP2 constitue la sortie du circuit amplificateur 9. Sur la figure, la diode sans seuil 12 est constituée par un troisième amplificateur opérationnel OP3 dont l'entrée non-inverseuse est connectée par une résistance R10 à la sortie du premier amplificateur OP1, et dont la sortie est connectée à l'anode d'une diode D2 dont la cathode est connectée au condensateur C1. L'entrée inverseuse de l'amplificateur OP3 est connectée à la cathode de la diode D2.

Le circuit amplificateur 9 est ainsi constitué par un amplificateur inverseur (OP1,R4,R5) de gain K1=R5/R4, d'une diode sans seuil 12, d'un condensateur C1 et d'un amplificateur différentiateur (OP2,R8,R9) de gain K2=R9/R8. A titre d'exemple, on peut choisir K1=100 et K2=10.

Le circuit amplificateur 9 fonctionne de la manière suivante:

La tension d'entrée du circuit étant nulle (commutateur ouvert), la tension d'offset Vo du premier amplificateur OP1 est multipliée par le gain K1 de celui-ci et le condensateur C1 se charge à une tension Vc=Vo.K1.

Cette valeur, correspondant à la tension d'offset amplifiée, est donc mise en mémoire dans le condensateur C1.

Lors de la fermeture du commutateur une tension positive Vf, correspondant à la tension aux bornes du fusible F, est appliquée sur l'entrée du circuit amplificateur 9. La tension V3 de sortie du premier amplificateur est alors donnée par:

$$V3 = (Vo-Vf).K1 \qquad (1)$$

Cette tension est inférieure à la tension de charge Vc du condensateur C1 et la diode sans seuil 12 interdit la décharge de celui-ci.
L'amplificateur différentiateur (OP2,R8,R9) amplifie la différence entre les tensions Vc et V3 et fournit en sortie une tension V4:

$$V4 = (Vc - V3).K2 = Vf.k1.K2 \qquad (2)$$

La tension obtenue en sortie du second amplificateur OP2 correspond bien à la tension Vf amplifiée, la tension d'offset d'OP1 étant corrigée automatiquement. La tension d'offset d'OP2 est, quant à elle, négligeable devant Vc-V3.

A titre d'exemple, pour Vo=10mV, Vf=100 microvolts, k1=100 et K2=10 on obtient:

$$Vc = 1v$$

$$V3 = 990mV$$

$$V4 = 100mV.$$

Un circuit, non représenté, de remise à zéro du condensateur C1 peut être prévu de manière à ce que la tension d'offset mémorisée soit correcte lors de la fermeture du commutateur.

Le circuit de commutation 6 de la figure 1 peut être commandé par des signaux de commande externes, le commutateur fonctionnant en contacteur. Les signaux de fermeture et d'ouverture appliqués au circuit à retard 4 peuvent également être fournis par des moyens internes de détection de défaut de manière à provoquer l'ouverture du commutateur lorsqu'une surcharge ou un court-circuit est détecté, des moyens de réarmement étant alors prévus pour provoquer la fermeture du commutateur qui fonctionne alors en disjoncteur. Les deux types de fonction, contacteur et disjoncteur, peuvent sans difficulté être réunies dans un même commutateur.

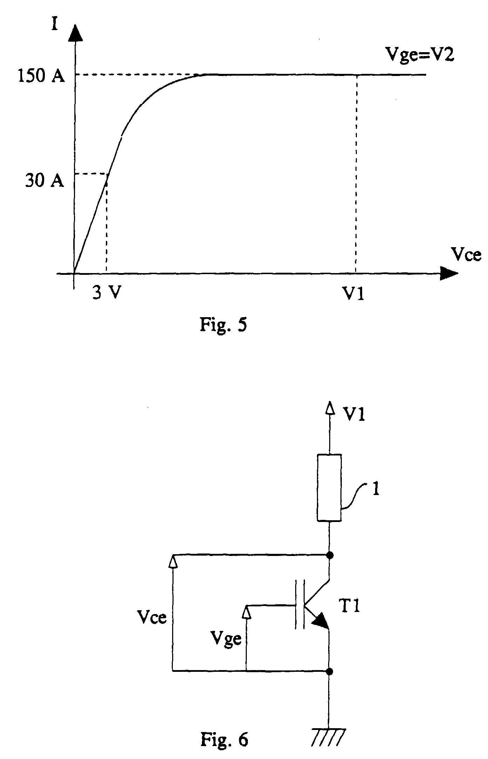

Les figures 5 et 6 illustrent le principe de la détection d'un défaut, et plus particulièrement d'un court-circuit, dans un commutateur statique, applicable notamment à un commutateur tel que décrit ci-dessus.

Contrairement aux circuits de détection de défaut connus, le principe décrit ci-dessous n'utilise pas de shunt de mesure destiné à mesurer le courant traversant le transistor T1. Selon l'invention, le tension Vce aux bornes du transistor T1 (figure 6) est utilisée pour détecter un défaut. En effet, pour une tension grille-émetteur Vge prédéterminée, par exemple égale à la tension d'alimentation V2, la caractéristique courant/tension du transistor T1 est du type représenté à la figure 5. Pour un courant nominal de fonctionnement prédéterminé, par exemple 30A, la tension Vce est de l'ordre de quelques volts, par exemple 3V. Par contre, en cas de surcharge, le courant augmente, au maximum jusqu'au courant de saturation, par exemple 150A, et la tension augmente substantiellement, pouvant atteindre la tension continue V1 d'alimentation du commutateur.

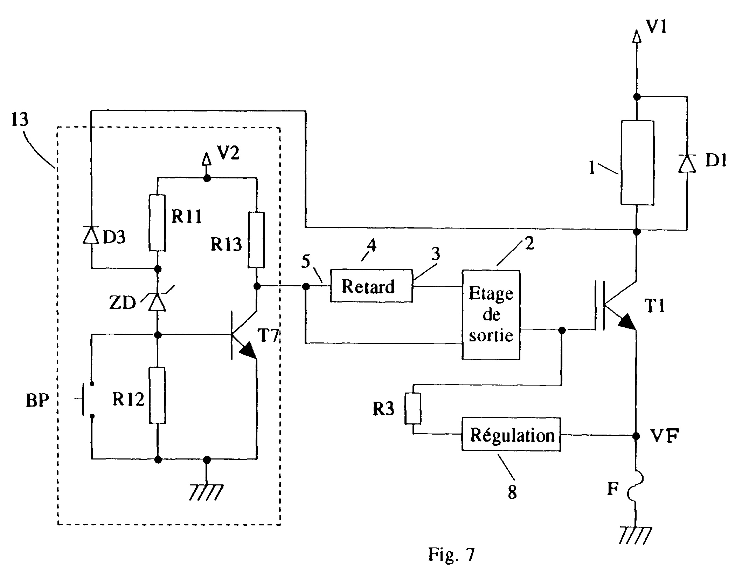

La figure 7 représente un commutateur du type représenté à la figure 1, comportant un mode particulier de réalisation d'un circuit 13 de détection d'un court-circuit.

La résistance du fusible F étant négligeable, la tension collecteur du transistor T1 est sensiblement égale à la tension Vce du transistor et est utilisée pour détecter un défaut. La cathode d'une diode D3 est connectée au collecteur du transistor T1. L'anode de la diode est reliée à la tension d'alimentation V2 par l'intermédiaire d'une résistance R11. Cette résistance est connectée en série, entre V2 et la masse, avec une diode Zener ZD et une résistance R12. Un transistor T7 a sa base connectée au point commun à la diode Zener ZD et à la résistance R12, son émetteur étant à la masse et son collecteur connecté à la tension d'alimentation V2 par une résistance R13. Le collecteur du transistor T7 constitue la sortie du circuit de détection 13 et fournit en cas de court-circuit, un signal de déclenchement, ou signal d'ouverture, destiné à être appliqué à l'entrée 5 du circuit à retard 4. Un bouton-poussoir BP de réarmement est connecté en parallèle sur la résistance R12.

En fonctionnement normal du commutateur, le transistor T1 est conducteur et parcouru par un courant nominal tel que la tension à ses bornes soit de l'ordre de 2 à 3V. La diode D3, polarisée par la résistance R11, est conductrice. La diode Zener ZD a une tension d'amorçage supérieure à la tension alors présente à l'anode de la diode D3 et elle est bloquée. Le transistor T7 est donc bloqué et la tension de sortie du circuit de détection 13 est à son niveau haut. Un signal de fermeture du commutateur reste appliqué au circuit à retard 4.

En cas de court-circuit, le courant I dans le transistor T1 devient très important, tout en restant limité à son courant de saturation, et la tension sur son collecteur augmente. Dès que cette tension dépasse la tension de polarisation de la diode D3, celle-ci se bloque et la diode Zener, polarisée par la résistance R11 et la tension d'alimentation V2 devient conductrice, rendant conducteur le transistor T7, dont le collecteur passe à zéro. Le signal de sortie du circuit de détection 13, passant à zéro, provoque le blocage du transistor T1 et l'ouverture du commutateur. La tension collecteur de T1 reste alors élevée (V1) et le circuit de détection 13 continue à fournir un signal d'ouverture (O) au circuit à retard.

La tension d'amorçage de la diode Zener ZD, par exemple 6,2V, est déterminée de manière à fournir un signal de défaut lorsque le transistor T1 est saturé. Le courant de défaut pendant un court-circuit est alors limité au courant de saturation correspondant à la tension appliquée à la grille de T1.

Pour réarmer le commutateur/disjoncteur le transistor T7 doit être bloqué, provoquant le passage à 1 du signal de sortie du circuit de détection de défaut 13. De tels moyens de réarmement sont schématisés sur la figure 7 par le bouton-poussoir BP dont la fermeture provoque le blocage du transistor T7. Le commutateur se ferme alors de la manière décrite en référence à la figure 1 et, dès que la tension collecteur du transistor T1 est suffisamment faible, la diode D3 redevient conductrice et maintient le blocage du transistor T7.

Le commutateur/disjoncteur peut être complété par un circuit de signalisation de défaut, par un circuit de détection de surcharge fournissant un signal d'ouverture en cas de détection d'une surcharge, ainsi que par un circuit de commande externe permettant de le faire fonctionner également en contacteur. Le circuit de détection de surcharge peut également utiliser les variations de la tension collecteur du transistor T1, le dépassement d'un certain seuil par la tension collecteur du transistor T1 pendant une durée prédéterminée étant représentative d'une surcharge.

## Revendications

1. Commutateur statique comportant un semi-conducteur (T1), destiné à être connecté en série avec une charge (1) aux bornes d'une tension d'alimentation continue (V1), et des moyens (2,4,8) de contrôle d'une tension de commande du semi-conducteur (T1) comportant des moyens (F) de mesure du courant parcourant le semi-conducteur et des moyens (8) de régulation de la tension de commande du semi-conducteur en fonction dudit courant, commutateur caractérisé en ce que les moyens de contrôle comportent un circuit à retard (4) sur une entrée (5) duquel est appliqué un signal de fermeture ou d'ouverture du commutateur, des moyens (2,T2) connectés à une sortie (3) du circuit à retard, destinés à produire une tension nominale de commande du semi-conducteur après une période de temporisation prédéterminée suivant l'application d'un signal de fermeture à l'entrée (5) du circuit à retard (4), la tension de commande régulée produite par les moyens de régulation (8) étant appliquée au semi-conducteur pendant ladite période de temporisation de manière à ce que le semi-conducteur fonctionne pendant cette période, en générateur de courant, limitant le courant à une valeur prédéterminée très inférieure au courant nominal du commutateur.

2. Commutateur selon la revendication 1, caractérisé en ce que les moyens de mesure du courant sont constitués par un fusible (F) connecté en série avec le semi-conducteur, la tension (Vf) aux bornes dudit fusible, représentative dudit courant, étant appliquée à l'entrée des moyens de régulation (8).

3. Commutateur selon l'une des revendications 1 et 2, caractérisé en ce que le courant est limité à environ 100mA pendant quelques secondes après la fermeture du commutateur.

4. Commutateur selon l'une quelconque des revendications 1 à 3, caractérisé en ce qu'il comporte des moyens (T5,T6) de mise à la masse de l'électrode de commande du semi-conducteur (T1) lorsqu'un signal d'ouverture du commutateur est appliqué à l'entrée (5) du circuit à retard ainsi que pendant un temps prédéterminé, très court, suivant l'application d'un signal de fermeture de manière à permettre une remise à zéro des moyens de régulation (8).

5. Commutateur selon l'une quelconque des revendications 1 à 4, caractérisé en ce que les moyens de régulation (8) comportent un circuit amplificateur (9) à correction automatique de la tension d'offset, à l'entrée duquel est appliquée la tension (Vf) représentative du courant, et un comparateur (10) comparant le signal de sortie du circuit amplificateur à un signal de référence (Vref), le circuit amplificateur (9) comportant un premier amplificateur opérationnel (OP1) dont la sortie (V3) est reliée à une première entrée (-) d'un second amplificateur opérationnel (OP2) et à une diode sans seuil (12) dont la cathode est connectée à un condensateur (C1), la tension (Vc) aux bornes du condensateur étant appliquée à la seconde entrée (+) du second amplificateur opérationnel (OP2) dont la sortie constitue la sortie du circuit amplificateur.

6. Commutateur selon l'une quelconque des revendications 1 à 5, caractérisé en ce qu'il comporte des moyens de détection de défaut produisant ledit signal d'ouverture en cas de détection d'une surcharge ou d'un court circuit, et des moyens de réarmement (BP) produisant ledit signal de fermeture.

7. Commutateur selon la revendication 6, caractérisé en ce que lesdits moyens de détection de défaut comportent des moyens (D3) de détection de la tension aux bornes du semi-conducteur et des moyens de production du signal d'ouverture lorsque cette tension dépasse un premier seuil prédéterminé pendant un temps prédéterminé, représentatifs d'une surcharge ou (13) lorsqu'elle dépasse un second seuil prédéterminé, représentatif d'un court-circuit, pour lequel le semi-conducteur est saturé.

8. Commutateur selon la revendication 7, caractérisé en ce que, le collecteur du semi-conducteur (T1) étant connecté à la tension d'alimentation continue (V1) par l'intermédiaire de la charge (1), les moyens de mesure de la tension aux bornes du semi-conducteur (T1) comportent une diode (D3) dont la cathode est connectée au collecteur du semi-conducteur (T1) et polarisée de manière à être bloquée lorsque ladite tension collecteur dépasse le second seuil, les moyens (13) de détection d'un court-circuit produisant un signal d'ouverture lorsque ladite diode (D3) est bloquée.

9. Commutateur selon l'une quelconque des revendications 1 à 8, caractérisé en ce que le semi-conducteur (T1) est un transistor bipolaire à grille isolée.

**Patentansprüche**

1. Elektronischer Schalter mit einem Halbleiter (T1), der dazu dient, in Serie mit einer Last (1) an die Klemmen einer Versorgungs-Gleichspannung (V1) angeschlossen zu werden, sowie mit auf eine Steuerspannung des Halbleiters (T1) wirkenden Steuermitteln (2, 4, 8), welche Mittel (F) zur Messung des den Halbleiter durchfließenden Stroms sowie Mittel (8) zur Regelung der Steuerspannung des Halbleiters in Abhängigkeit vom genannten Strom umfassen, dadurch gekennzeichnet, daß die Steuermittel ein Verzögerungsglied (4), das an einem (5) seiner Eingänge mit einem Einschalt- bzw. Ausschaltsignal des Schalters beaufschlagt wird, sowie an einen Ausgang (3) des Verzögerungsglieds angeschlossene Mittel (2, T2) zur Erzeugung einer Nenn-Steuerspannung des Halbleiters nach dem Ablauf einer, auf die Beaufschlagung des Eingangs (5) des Verzögerungsglieds (4) mit einem Einschaltsignal folgenden, festgelegten Verzögerungszeit umfassen, wobei der Halbleiter während der genannten Verzögerungsdauer mit der durch die Regelungsmittel (8) erzeugten, geregelten Steuerspannung beaufschlagt wird, derart daß der Halbleiter während dieser Zeitspanne als Stromquelle wirkt und dabei den Strom auf einen, wesentlich unter dem Nennstrom des Schalters liegenden, festgelegten Wert begrenzt.

2. Schalter nach Anspruch 1, dadurch gekennzeichnet, daß die Strommeßmittel aus einer, in Serie mit dem Halbleiter geschalteten Sicherung (F) bestehen, wobei die den genannten Strom abbildende Spannung (Vf) an den Klemmen der genannten Sicherung dem Eingang der Regelungsmittel (8) zugeführt wird.

3. Schalter nach Anspruch 1 oder 2, dadurch gekennzeichnet, daß der Strom während einiger Sekunden nach dem Einschalten des Schalters auf etwa 100 mA begrenzt wird.

4. Schalter nach irgendeinem der Ansprüche 1 bis 3, dadurch gekennzeichnet, daß er Mittel (T5, T6) zur Verbindung der Steuerelektrode des Halbleiters (T1) mit Masse umfaßt, wenn der Eingang (5) des Verzögerungsglieds mit einem Ausschaltsignal des Schalters beaufschlagt wird, sowie während einer festgelegten, sehr kurzen Zeitspanne nach Beaufschlagung mit einen Einschaltsignal, derart daß ein Rücksetzen der Regelungsmittel (8) ermöglicht wird.

5. Schalter nach irgendeinem der Ansprüche 1 bis 4, dadurch gekennzeichnet, daß die Regelungsmittel (8) eine Verstärkerschaltung (9) mit automatischer Korrektur der Offsetspannung, deren Eingang mit der den Strom abbildenden Spannung (Vf) beaufschlagt wird, sowie ein Komparatorglied (10) umfassen, welches das Ausgangssignal der Verstärkerschaltung mit einem Referenzsignal (Vref) vergleicht, wobei die Verstärkerschaltung (9) einen ersten Operationsverstärker (OP1) umfaßt, dessen Ausgang (V3) an einen ersten Eingang (-) eines zweiten Operationsverstärkers (OP2) sowie an eine schwellwertfreie Diode (12) angeschlossen ist, deren Kathode mit einem Kondensator (C1) verbunden ist, wobei die Klemmenspannung (Vc) des Kondensators auf den zweiten Eingang (+) des zweiten Operationsverstärkers (OP2) gelegt wird, dessen Ausgang den Ausgang der Verstärkerschaltung bildet.

6. Schalter nach irgendeinem der Ansprüche 1 bis 5, dadurch gekennzeichnet, daß er Fehlererfassungsmittel, die bei Erfassung einer Überlast oder eines Kurzschlusses das genannte Ausschaltsignal erzeugen, sowie Rückstellmittel (BP) umfaßt, welche das genannte Einschaltsignal erzeugen.

7. Schalter nach Anspruch 6, dadurch gekennzeichnet, daß die Fehlererfassungsmittel des Schalters Mittel (D3) zur Erfassung der Spannung an den Klemmen des Halbleiters sowie Mittel zur Erzeugung des Ausschaltsignals umfassen, wenn diese Spannung während einer bestimmten Zeit einen festgelegten, eine Überlast abbildenden ersten Schwellwert überschreitet, oder (13) wenn sie einen zweiten festgelegten Schwellwert überschreitet, der einen Kurzschluß abbildet und bei dem der Halbleiter gesättigt ist.

8. Schalter nach Anspruch 7, dadurch gekennzeichnet, daß die Mittel zur Messung der Spannung an den Klemmen des Halbleiters (T1) bei Anschluß des Kollektors des Halbleiters (T1) über die Last (1) an die Versorgungs-Gleichspannung (V1) eine Diode (D3) umfassen, deren Kathode an den Kollektor des Halbleiters (T1) angeschlossen und die so vorgespannt ist, daß sie in den Sperrzustand schaltet, wenn die genannte Kollektorspannung den zweiten Schwellwert überschreitet, wobei die Mittel (13) zur Erfassung eines Kurzschlusses bei Sperrung der genannten Diode (D3) ein Ausschaltsignal erzeugen.

9. Schalter nach irgendeinem der Ansprüche 1 bis 8, dadurch gekennzeichnet, daß der Halbleiter (T1) als Bipolar-Transistor mit isoliertem Gate ausgeführt ist.

## Claims

1. A static switch comprising a semi-conductor (T1), designed to be connected in series with a load (1) to the terminals of a DC voltage supply (V1), and means (2, 4, 8) for controlling an operating voltage of the semi-conductor (T1) comprising means (F) for measuring the current flowing in the semi-conductor and means (8) for regulating the operating voltage of the semiconductor in terms of said current, a switch characterized in that the control means comprise a time delay circuit (4) to one of whose inputs (5) a switch closing or opening signal is applied, means (2, T2) connected to an output (3) of the time delay circuit designed to produce a rated operating voltage of the semi-conductor after a preset time delay period following application of a closing signal to the input (5) of the time delay circuit (4), the regulated operating voltage produced by the regulating means (8) being applied to the semi-conductor during said time delay period so that the semi-conductor operates during this period as a current generator, limiting the current to a preset value much lower than the rated current of the switch.

2. The switch according to claim 1, characterized in that the means for measuring the current are formed by a fuse (F) connected in series with the semi-conductor, the voltage (Vf) at the terminals of said fuse, representative of said current, being applied to the input of the regulating means (8).

3. The switch according to either one of the claims 1 or 2, characterized in that the current is limited to approximately 100mA for a few seconds after closing of the switch.

4. The switch according to any one of the claims 1 to 3, characterized in that it comprises means (T5, T6) for grounding the control electrode of the semi-conductor (T1) when a switch opening signal is applied to the input (5) of the time delay circuit and during a very short preset time following application of a closing signal so as to enable the regulating means (8) to be zero reset

5. The switch according to any one of the claims 1 to 4, characterized in that the regulating means (8) comprise an amplifying circuit (9) with automatic correction of the offset voltage, to whose input the voltage (Vf) representative of the current is applied, and a comparator (10) comparing the output signal of the amplifying circuit with a reference signal (Vref), the amplifying circuit (9) comprising a first operational amplifier (OP1) whose output (V3) is connected to a first input (-) of a second operational amplifier (OP2) and to a no-threshold diode (12) whose cathode is connected to a capacitor (C1), the voltage (Vc) at the terminals of the capacitor being applied to the second input (+) of the second operational amplifier (OP2) whose output constitutes the output of the amplifying circuit.

6. The switch according to any one of the claims 1 to 5, characterized in that it comprises fault detection means producing said opening signal in the event of an overload or short-circuit being detected, and resetting means (BP) producing said closing signal.

7. The switch according to claim 6, characterized in that said fault detection means comprise means (D3) for detecting the voltage at the terminals of the semi-conductor and means for producing the opening signal when this voltage exceeds a first preset threshold for a preset time, representative of an overload, or (13) when it exceeds a second preset threshold, representative of a short-circuit, for which the semi-conductor is saturated.

8. The switch according to claim 7, characterized in that, the collector of the semi-conductor (T1) being connected to the DC voltage supply (V1) via the load (1), the means for measuring the voltage at the terminals of the semi-conductor (T1) comprise a diode (D3) whose cathode is connected to the collector of the semi-conductor (T1) and polarized in such a way as to be turned off when said collector voltage exceeds the second threshold, the short-circuit detection means (13) producing an opening signal when said diode (D3) is turned off.

9. The switch according to any one of the claims 1 to 8, characterized in that the semi-conductor (T1) is a bipolar transistor with insulated gate.

Fig. 1

Fig. 2

Fig. 3

Fig. 4

I

150 A

30 A

Vge=V2

3 V          V1          Vce

**Fig. 5**

V1

1

T1

Vce

Vge

**Fig. 6**

Fig. 7